## Europäisches Patentamt
## European Patent Office
## Office européen des brevets

(11) Publication number: **0 023 573**
**B1**

(12) **EUROPEAN PATENT SPECIFICATION**

(45) Date of publication of patent specification: **07.11.84**

(51) Int. Cl.³: **C 23 C 15/00**

(21) Application number: **80103730.0**

(22) Date of filing: **01.07.80**

(54) **Sputtering system to process a batch of wafers.**

(30) Priority: **23.07.79 US 59718**

(43) Date of publication of application:
**11.02.81 Bulletin 81/06**

(45) Publication of the grant of the patent:
**07.11.84 Bulletin 84/45**

(84) Designated Contracting States:
**DE FR GB**

(56) References cited:
EP-A-0 006 475
DE-A-2 125 936
FR-A-2 270 678
US-A-3 537 973

SOLID STATE TECHNOLOGY, vol. 18, no. 12,
December 1975, pages 34-40 T.C. TISONE:
"Low voltage triode sputtering with a confined
plasma"
IBM TECHNICAL DISCLOSURE BULLETIN, vol.
17, no. 8, January 1975, New York, U.S.A. Y.
BUDO et al.: "Automated RF sputtering
apparatus", pages 2324-2325

(73) Proprietor: **International Business Machines
Corporation
Old Orchard Road
Armonk, N.Y. 10504 (US)**

(72) Inventor: **Galicki, Arkadi
1402 Courtyard Drive
San Jose California 95118 (US)**
Inventor: **Hayunga, Carl Peter
42 Colette Drive
Poughkeepsie New York 12601 (US)**
Inventor: **Sarkary, Homi Gustadji
29 Verplank Avenue
Hopewell Junction New York 12533 (US)**

(74) Representative: **Oechssler, Dietrich, Dr.rer.nat.
Dipl.-Chem.
Schönaicher Strasse 220
D-7030 Böblingen (DE)**

(56) References cited:
IBM TECHNICAL DISCLOSURE BULLETIN, vol.
19, no. 2, July 1976, pages 516-517 New York,
U.S.A. H.M. GARTNER et al.: "Compensation
mechanism for uniform sputtering"

Courier Press, Leamington Spa, England.

# Description

The invention relates to a sputtering system with two plane electrode plates facing one another and arranged in parallel in which wafers to be processed are supported on the surface of the one electrode plate in the gap between the electrode plates.

In conventional sputtering of quartz the usual sputter deposition chamber utilizes a cathode and an anode spaced in opposed relationship with the wafers resting upon the anode. The spacing between the cathode and anode is normally fixed depending upon the size of the plates and other deposition parameters of the system. Since wafers worked upon in batch quantities normally have the same thickness, then the distance between the top surface of a given wafer on the anode plate to the cathode is essentially constant.

Despite this uniformity of distance it has been found that the field effects and deposition field intensity within the sputtering region vary from wafer to wafer. Accordingly, the conventional sputtering systems result in nonuniformity of quartz deposition upon the wafer. For example, in a conventional 40 MHz sputtering system adapted to deposit about 2,500 nm of quartz upon each wafer, it would not be unusual to have a variation of as much as 300 nm in the thickness of quartz deposited upon a given wafer, particularly if the wafer is located at the outer periphery of the anode plate where field effect variations are more significant. This uniformity variation is generally unsatisfactory for the processing of wafers to achieve high yields.

In particular such a thickness variation in the quartz leads to difficulties in opening of vias in later processing steps, which results in failure of product.

In prior work described in IBM Technical Disclosure Bulletin, Vol. 19, No. 2, July 1976, pages 516 one of the inventors herein discloses that, in part, the variations in quartz deposition thickness can be correlated to the spacing of the top surface of the wafer from the adjacent surface of the source material. Consequently compensation for such differences in distribution can be provided by varying the individual spacing of the wafers and source in accordance with coating differences found.

One solution proposed in that publication, to achieve uniformity, utilized spaces under wafers on the anode plate to change the dimensional spacing of a given wafer with respect to the cathode.

The aforementioned system modified quartz distribution deposition thickness to some extent, particularly with respect to variations occurring in one wafer versus another in a batch. However, the solution proposed does not solve thickness variation problems existing on a given wafer within a batch.

Also in the article "low voltage diode sputtering with a confined plasma" published in Solid State Technology Vol. 18, No. 12, December 1975, page 34, a concept of varying the individual spacing of the wafers and the target is described as means to improve the uniformity of the film growth. In this article also the combination of the varying spacing and a tilting by 17° of the wafers with respect to an axis through the center of the table is mentioned as a possibility to accomplish a uniformity of the film growth over a wafer and between the wafers of less then 5%. The construction of the substrate table in the described system is rather complicated and very different from conventional substrate tables and the adjustment of the process parameter appears difficult, since 2 parameter, the spacing and the tilt angle, have to be determined.

The object of the invention are to provide a sputtering system to treat the surface of wafers that differs only slightly from conventional systems where the treatment is not only homogenous for multiple simultaneously processed wafers of a batch, but also throughout the surface of the individual wafers and where the adjustment of the process parameters is simple, and to indicate applications for such a system.

These objects are achieved by a sputtering system as defined at the beginning of this specification, with the features of the characterizing part of claim 1 and with applications of such a system as characterized in claims 8 and 10.

To achieve these objects only a relatively simple modification of the electrode plate that supports the wafers is necessary. The optimum inclination angle for a specific wafer diameter and a wafer position at a fixed distance from the center of the other electrode plate is advantageously determined by a series of simple experiments, in which the sputtering treatment is performed for various inclination angles.

In one preferred embodiment of the invention the wafer sputtering system having a diameter of about 80 mm and a distance between about 7.6 and about 25.4 cm of the wafer center from the center of the other electrode plate are tilted between about 0.4 and about 1.5° relative to the surface of the other electrode plate.

In another preferred embodiment of the inventive sputtering system the wafers having a distance between about 15.2 and about 25.4 cm from the center of the other electrode plate are tilted between about 0.6 and about 1.2°.

In a third preferred embodiment of the inventive sputtering system the wafers having a distance between about 7.62 and about 15.24 cm from the center of the other electrode plate is tilted between about 0.4 and about 1.0°.

In a fourth preferred embodiment of the inventive sputtering system the wafers having a distance of about 12.7 cm from the center of the other electrode is tilted 0.8°.

In a fifth preferred embodiment of the inventive sputtering system according to claim 1, in which the wafers having a diameter of about 12.7 cm and a distance of the wafer center from the center of the other electrode plate between about 20.3 and about 30.4 cm is tilted between about 0.8 and about 1.4°.

It is advantageous to provide recesses with an inclined bottom in the one electrode plate to receive the wafers. These recesses are favourably arranged in the one electrode plate in concentric or fanned orientations relative to the center of the other electrode plate.

The inventive sputtering system is especially suitable for depositing on wafers layers of matter having a uniform thickness, but is also useful in homogeneously thinning or removing existing layers of matters.

Advantageous embodiments of the inventive sputtering system and its inventive applications are disclosed in the subclaims.

The invention will become more apparent from the following detailed description taken in conjunction with the accompanying drawings wherein,

Fig. 1 comprises a top plan view of an anode plate having concentrically arranged wafers located thereon;

Fig. 2 is a cross section of part of the anode plate of Fig. 1, of the cathode plate and the chamber wall; and

Fig. 3 is a diagram illustrating data relating to the invention.

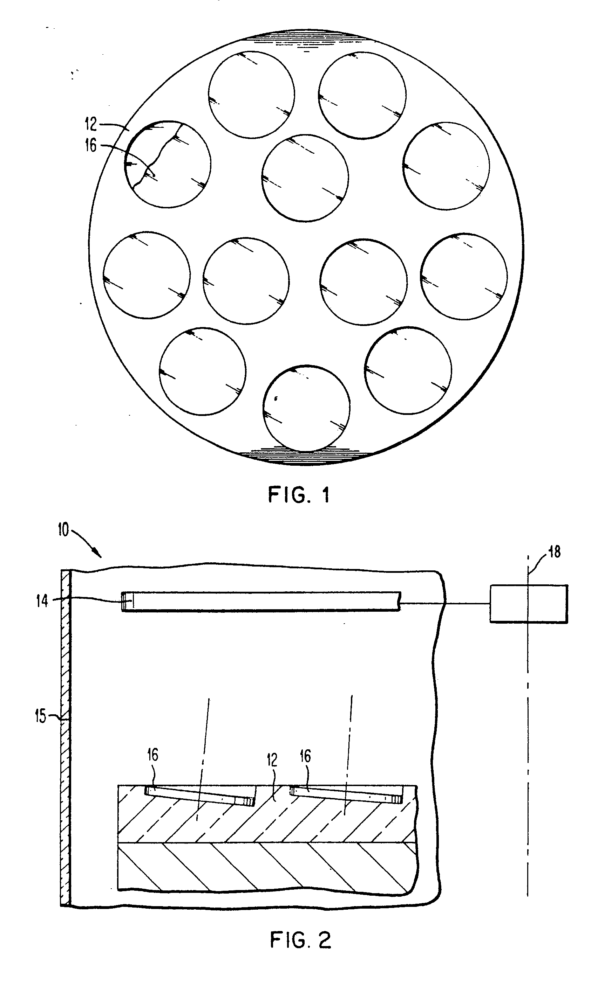

Referring now to the drawings and particularly to Figs. 1 and 2 one preferred embodiment of the invention is described comprising a sputtering system schematically indicated by numeral 10 including an anode plate 12 and a cathode plate 14 spaced apart to define a sputtering region therebetween, in well known fashion. The sputtering system comprises a conventional system confined within a chamber including wall 15. The parameters of the system can be adjusted depending upon the size of wafers to be processed and the thickness of quartz to be deposited, again in conventional fashion.

The anode plate comprises a structure adapted to twelve wafers at a time for batch processing, with each wafer being received within a cylindrical recess 16 formed in the anode plate. It should be apparent that the wafers are arranged in two rings oriented concentrically about the center line of the anode plate, with nine wafers in the outer ring and three in the inner ring. The center line of anode plate 12 is coincident with the center line of cathode plate 14 or the system center line 18 respectively.

The recesses receiving the wafers are formed with an angular bottom slope which tilts the wafer received therein with respect to the cathode plate. All of the wafers in each ring are tilted at the same angle, but the orientation of the tilt is such that each wafer space is opened toward the center of the ring.

In the preferred embodiment, 82.55 mm wafers in the outer ring are tilted at an angle near 0.8 degrees with respect to the horizontal. The center of the wafers was located at a distance about 12.7 cm from the center of the cathode plate. Quartz deposition of a thickness of about 2,400 nm was achieved in the chamber with good planarity. This type of deposition can be carried out in conventional fashion in reactors with input power in the 3—5 kilowatt range, with anode voltage ranging from 5—850 volts and with the usual argon pressure of 13.33—40 $\mu$bar. An inner electrode spacing of about 25.4 mm between anode and cathode was utilized. Deposition rates of approximately 10—50 nm per minute can be achieved under such circumstances.

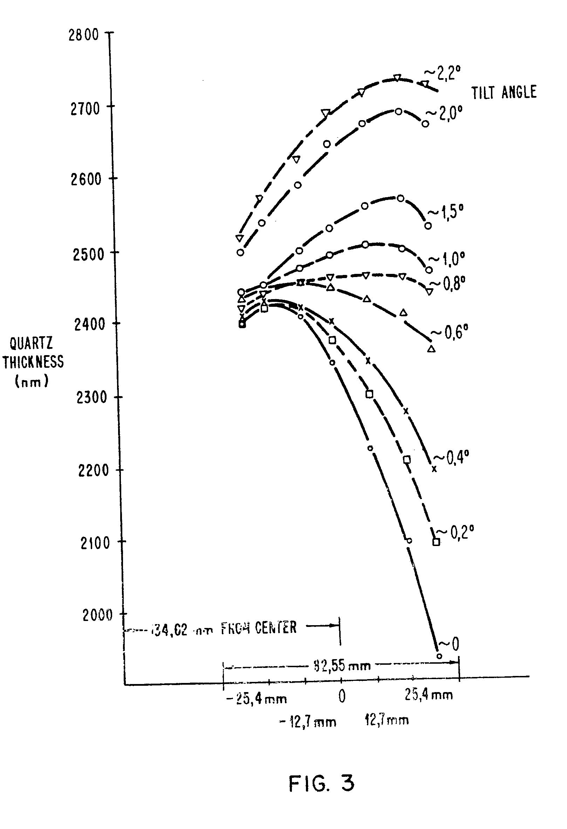

Figure 3 illustrates data taken in such a chamber with wafers oriented at different angles of tilt which demonstrates the planarity of quartz uniformity achievable at different angles of tilt with respect to the cathode, again with 82.55 mm wafers oriented about 12.7 cm from the center of the cathode. It should be apparent from the data that the uniformity or deposition planarity varies from very poor results attained at 0 degrees tilt to good results attained between .6 and .8 degrees tilt. Moreover, the data illustrates that the quartz uniformity begins to worsen as the angle of tilt exceeds 1.5 degrees and approaches 2 degrees, for example. In view of this data it is believed that the preferred or optimum angle of tilt is about .8 degrees although angles ranging between .4 degrees and 1.5 degrees are certainly preferable with respect to the result attained at angles of 0 degrees tilt or tilt beyond 2.0 degrees.

The data illustrated in Fig. 3 includes points taken by actual measurement at 0 degrees tilt, .4, .6, 1.5 and 2.0 degrees tilt. The other data points, illustrated in dotted outline in the Figure, were obtained by plotting estimates of the linear, quadratic and cubic terms of the uniformity versus angle results and reconstructing the curve for other values of tilt angle. Additional points at .2, .8, 1.0 and 2.2 are plotted with the original data. These reconstructed points appear to be consistent with and extend the range of the original data.

Thus, analyzing the data in experimental form, it appears that the plasma density, and thus the sputter removal rate at the target, increases with the radial position of the wafer with respect to the anode center to a maximum near a radial position of about 12.7 cm. This increase is due to an increase in the radial frequency current density as it varies with respect to radial position.

The nonuniformity increases for a radial position past that of maximum plasma density. The deposition rate is determined by the amount of material incident upon the wafer, and the amount resputtered or re-emitted. The amount incident upon the wafer can be determined by the orientation of the wafer with respect to the anode-cathode relationship. Thus the quantity of material deposited can be increased by tilting the wafer toward an area on the target where the sputtering rate is larger. The resputtering voltage is determined by the RF voltage on the anode and the average thickness of the quartz under the wafer as that affects the capacitance coupling to the wafer. It is believed that the entire wafer is at nearly the same potential due to the conductivity of the silicon and the impedance of the anode sheet and plate.

Consequently, the dominant effect of wafer tilting appears to be an increase in the incident flux of silicon dioxide per unit area for a given position on the wafer. This in effect causes an increase of the flux to that part of the wafer where the deposition rate would otherwise be lowest. The technique described results in an improved quartz uniformity on wafers which cannot otherwise be attained in batch processing systems.

It should be apparent that other wafer configurations on the anode could be utilized, if desired, For example, wafers could be processed in different groupings, or in fanned configuration. In that event, the wafers would be located at different radii from the center of the anode. Consequently, the optimum angle of tilt for each wafer would be different from that illustrated in the preferred embodiment. However, this deposition angle can easily be identified by theoretical analysis after data is taken in a particular chamber.

The data illustrated in Fig. 3 represents the quartz thickness measured at 7 points spaced across the diameter of a given wafer. The thickness deviation for wafers oriented at an angle of 0.6 degrees is believed to be about ±2.9% whereas the thickness deviation of wafers oriented at 0 degrees amounts to over ±11%. Thus, a significant improvement in quartz uniformity is apparent. At an angle of above 2.0 degrees, the quartz uniformity begins to deteriorate; however, it is still superior to that attained without tilt.

## Claims

1. Sputtering system with two plane electrode plates facing one another and arranged in parallel in which wafers (16) to be processed are supported on the surface of the one electrode plate (12) in the gap between the electrode plates, characterized in that the wafers (16) are supported on the one electrode plate (12) in such a way that the surface of the wafers 16) forms an angle distinct from zero and not greater than 2° with the opposite surface of the other electrode plate (14), this angle being that providing the optimum inclination to minimize thickness variations on each individual wafer (16), determined experimentally having regard to the diameter of each wafer (16) and its distance from the center of the other electrode plate (14) and that the normal on the surface of wafers (16) is tilted toward the center of the other electrode plate (14).

2. Sputtering system according to claim 1 in which the wafer (16) having a diameter of about 80 mm and a distance between about 7.6 and about 25.4 cm of the wafer center from the center of the other electrode plate (14) is tilted between about 0.4 and about 1.5° relative to the surface of the other electrode plate (14).

3. Sputtering system according to claim 2 in which the wafer (16) having a distance between about 15.2 and about 25.4 cm from the center of the other electrode plate (14) is tilted between about 0.6 and about 1.2°.

4. Sputtering system according to claim 2, in which the wafer (16) having a distance between about 7.62 and 15.24 cm from the center of the other electrode plate (14) is tilted between about 0.4 and about 1.0°.

5. Sputtering system according to claim 4 in which the wafer (16) having a distance of about 12.7 cm from the center of the other electrode (14) is tilted 0.8°.

6. Sputtering system according to claim 1, in which the wafer (16) having a diameter of about 12.7 cm and a distance of the wafer center from the center of the other electrode plate (14) between about 20.3 and about 30.4 cm is tilted between about 0.8 and about 1.4°.

7. Sputtering system according to one or several of claims 1 to 6, in which recesses with an inclined bottom are provided in the one electrode plate (12) to receive wafers (16).

8. Application of a sputtering system according to one or several of claims 1 to 7 depositing a layer of matter on wafers (16) where the one electrode plate (12) serves as anode and the other electrode plate (14) as cathode.

9. Application according to claim 8, in which a quartz layer is deposited on wafers (16).

10. Application of a sputtering system according to one or several of claims 1 to 7 for thinning or removing existing layers of matter.

## Patentansprüche

1. Kathodenzerstäubungssystem mit zwei ebenen, sich parallel gegenüberliegenden Elektrodenplatten, in welchem zu verarbeitende Wafer (16) auf der Oberfläche der einen Elektrodenplatte (12) in der Lücke zwischen den Elektrodenplatten vorgesehen sind, dadurch gekennzeichnet, daß die Wafer (16) in solcher Weise auf der einen Elektrodenplatte (12) vorgesehen sind, daß ihre Oberfläche (16) einen Winkel mit der gegenüberliegenden Fläche der anderen Elektrodenplatte (14), bildet, der nicht Null und nicht größer als 2° ist, wobei dieser Winkel so groß gemacht wird, daß er die optimale Neigung bezüglich der Niedrighaltung der Dichenschwankungen auf jedem einzelnen Wafer (16) darstellt, was experimentell bezüglich des Durchmessers jedes Wafers (16) und seiner Entfernung von dem Mittelpunkt der anderen Elektrodenplatte (14) bestimmt wird, und daß die Normale auf der Oberfläche der Wafer (16) zum Mittelpunkt der anderen Elektrodenplatte (14) hin geneigt ist.

2. Kathodenzerstäubungssystem nach Anspruch 1, in welchem der Wafer (16) mit einem Durchmesser von ungefähr 80 mm und einer Entfernung zwischen ca. 7,6 und ca. 25,4 cm des Wafermittelpunkts vom Mittelpunkt der anderen Elektrodenplatte (14) zwischen ungefähr 0,4 und ungefähr 1,5° zu der Oberfläche der anderen Elektrodenplatte (14) geneigt ist.

3. Kathodenzerstäubungssystem nach Anspruch 2, in welchem der Wafer (16) mit einer Entfernung zwischen ungefähr 15,2 und ungefähr 25,4 cm vom Mittelpunkt der anderen Elektrodenplatte (14) um ca. 0,6 und ca. 1,2° geneigt ist.

4. Kathodenzerstäubungssystem nach Anspruch 2, in welchem der Wafer (16) mit einer Entfernung zwischen ca. 7,62 un ca. 15,24 cm vom Mittelpunkt der anderen Elektrodenplatte (14) um ca. 0,4 und ca. 1,0°· geneigt ist.

5. Kathodenzerstäubungssystem nach Anspruch 4, in welchem der Wafer (16) mit einer Entfernung von ca. 12,7 cm vom Mittelpunkt der anderen Elektrodenplatte (14) um 0,8° geneigt ist.

6. Kathodenzerstäubungssystem nach Anspruch 1, in welchem der Wafer (16) mit einem Durchmesser von ca. 12,7 cm und einer Entfernung des Wafermittelpunkts vom Mittelpunkt der anderen Elektrodenplatte (14) zwischen ca. 20,3 und ca. 30,4 cm zwischen ca. 0,8 und ca. 1,4° geneigt ist.

7. Kathodenzerstäubungssystem nach einem oder mehreren der Ansprüche 1 bis 6, in welchem Vertiefungen mit geneigtem Boden in der einen Elektrodenplatte (12) zur Aufnahme der Wafer (16) vorgesehen sind.

8. Anwendung eines Kathodenzerstäubungssystems nach einem oder mehreren der Ansprüche 1 bis 7 zur Aufbringung einer Materialschicht auf Wafern (16), wobei die eine Elektrodenplatte (12) als Anode und die andere Elektrodenplatte (14) als Kathode verwendet wird.

9. Anwendung nach Anspruch 8, in welchem eine Quarzschicht auf den Wafern (16) aufgebracht wird.

10. Anwendung eines Kathodenzerstäubungssystems nach einem oder mehreren des Ansprüche 1 bis 7 zum Verdünnen oder Entfernen von vorhandenden Materialschichten.

**Revendications**

1. Système de traitement par pulvérisation à deux plaques d'électrodes planes disposées face à face et parallèlement l'une à l'autre dans lequel des pastilles (16) à traiter sont disposées sur la surface d'une plaque d'électrode (12) dans l'intervalle entre lesdites plaques d'électrodes, caractérisé en ce que: les pastilles (16) sont disposées sur la plaque d'électrode (12) de telle manière que la surface des pastilles (16) fasse un angle différent de 0 et n'excédant pas 2° avec la surface opposée de la seconde plaque d'electrode (14), cet angle étant l'angle assurant l'inclinaison optimale permettant de minimiser les variations d'épaisseur de chaque pastille individuelle (16), déterminé expérimentalement en fonction du diamètre de chaque pastille (16) et de sa distance du centre de la seconde plaque d'électrode (14) et en ce que la normale sur la surface des pastilles (16) est basculée vers le centre de la seconde plaque d'électrode (14).

2. Système de traitement par pulvérisation selon la revendication l'dans lequel la pastille (16) ayant un diamètre de l'ordre de 80 mm et étant à une distance approximativement comprise entre, 7,6 et 25,4 cm du centre de la seconde plaque d'électrode (14) est basculée sur un angle de l'ordre de 0,4 à 1,5° par rapport à la surface de la seconde plaque d'électrode (14).

3. Système de traitement par pulvérisation selon la revendication 2 dans lequel la pastille (16) étant à une distance approximativement comprise 15,2 et 25,4 cm du centre de la seconde plaque d'électrode (14) est basculée sur un angle de l'ordre de 0,6 à 1,2°.

4. Système de traitement par pulvérisation selon la revendication 2 dans lequel la pastille (16) étant à une distance approximativement comprise entre 7,62 et 15,24 cm du centre de la seconde plaque d'électrode (14) est basculée sur un angle de l'ordre de 0,4 à 1,0°.

5. Système de traitement par pulvérisation selon la revendication 4 dans lequel la pastille 16) étant à une distance de l'ordre de 12,7 cm du centre de la seconde électrode (14), est basculée de 0,8°.

6. Système de traitement par pulvérisation selon la revendication 1 dans lequel la pastille (16) ayant un diamètre de l'ordre de 12,7 cm et étant à une distance approximative du centre de la seconde plaque d'électrode (14) comprise entre 20,3 et 30,4 cm, est basculée sur un angle de l'ordre de 0,8 à 1,4°.

7. Système de traitement par pulvérisation selon l'une ou plusieurs des revendications 1 à 6, dans lequel des évidements à fond incliné sont prévus dans la plaque d'électrode (12) pour recevoir des pastilles (16).

8. Application d'un système de traitement par pulvérisation selon l'une ou plusieurs des revendications 1 à 7, au dépôt d'une couche de matière sur des pastilles (16) dans laquelle le plaque d'électrode (12) est utilisée comme anode et la seconde plaque d'électrode (14) comme cathode.

9. Application selon la revendication 8 dans laquelle une couche de quartz est déposée sur des pastilles (16).

10. Application d'un système de traitement par pulvérisation selon l'une ou plusieurs des revendications 1 à 7, à l'amincissement ou au retrait des couches de matière existant.

FIG. 1

FIG. 2

FIG. 3